# EUROPEAN PATENT APPLICATION

(11) **EP 4 844 387 A1**
(43) Date of publication of application: **25.11.2026**
(21) Application number: 25177901.3
(22) Date of filing: 21.05.2025
(51) Int. Cl.: G01N 23/2251

(54) **A METHOD OF TIME-RESOLVED TRANSMISSION CHARGED PARTICLE MICROSCOPY**

(71) Applicant: FEI COMPANY, Hillsboro, OR 97124 (US)
(72) Inventor: Van den Broek, Wouter, 3543 GE Utrecht (NL); Bongiovanni, Gabriele, 5602 BS Eindhoven (NL)
(74) Representative: Robinson, Louise Frances

(57) **Abstract**

The disclosure relates to a method of time-resolved Transmission Charged Particle Microscopy, such as a time-resolved transmission electron microscope. The method involves using a primary source (4) to produce a pulsed beam of charged particles that propagate along a defined beam path (B) towards a specimen (S) positioned at an irradiation location. A secondary source (51), such as laser, produces excitations of the specimen (S). A detector (34) registers a plurality of diffraction patterns resulting from the interaction of the pulsed beam with the specimen (S). An image of the specimen (S) is reconstructed from these diffraction patterns using a reconstruction algorithm, like a phase retrieval algorithm as used in ptychography. This method enables high-resolution, time-resolved imaging of specimens, facilitating the study of dynamic processes at the nanoscale by accurately capturing and reconstructing the interactions between the pulsed beam and the specimen (S).

## Description

The disclosure relates to a method and system for time-resolved Transmission Charged Particle Microscopy.

Transmission Electron Microscopy (TEM) is a powerful imaging technique that utilizes a beam of electrons transmitted through an ultra-thin specimen to form an image. The electrons interact with the specimen as they pass through it, providing detailed information about its internal structure at very high resolution. TEM is widely used in various fields such as materials science, biology, and nanotechnology for its ability to reveal fine structural details at the atomic or molecular level.

Time-resolved TEM is an advanced variation of conventional TEM that allows for the observation of dynamic processes within a specimen over time. This is typically achieved by using ultrafast electron pulses to capture a sequence of images or diffraction patterns that reveal changes in the specimen's structure at different time intervals. One common method involves using a pulsed electron beam generated by a laser-driven photocathode, which can produce electron pulses lasting as short as femtoseconds (10⁻¹⁵ seconds) or picoseconds (10⁻¹² seconds). These pulses are synchronized with an external excitation source, such as a laser, to initiate and probe dynamic events in the specimen.

An example of time-resolved transmission charged particle microscopy is formed by so-called laser pump-pulse microscopy, in which laser pulses are used to trigger a repeatable/reproducible temporal process in the specimen under study. Examples of temporal processes in this context include phase transitions, plasmonic excitations, mechanical vibrations, ablative processes, heat flow, chemical reactions, etc. In the pump-probe method, a laser pulse (pump) excites the specimen to induce a dynamic event, and an electron pulse (probe) is used to capture an image of the specimen at specific time delays after the excitation. By varying the delay between the pump and probe pulses, a series of images can be obtained, each representing a different stage of the dynamic process. Stroboscopic imaging is another technique where a non-continuous electron beam is used in combination with periodic excitation of the specimen. The specimen is excited at regular intervals, and the electron beam captures images at specific phases of the excitation cycle. This method relies on the process being perfectly repeatable to build up a time-resolved sequence through temporal averaging. For a specific description of a specimen investigation of this type, see, for example, the journal article by D. R. Cremons et al., Femtosecond electron imaging of defect-modulated phonon dynamics, Nature Communications 7, article #11230 (2016): www.nature.com/articles/ncomms11230.

In US10032599B2, in name of applicant, an improvement of time-resolved charged particle microscopy is provided. Here, charged particles that traverse the specimen after each said excitation are detected, including a time-of-arrival of individual charged particles that traverse the specimen. A detector is used that includes an integrated array of pixels, each with an individual readout circuit. With the above, a greatly improved temporal resolution is obtained.

Despite the advancements, these conventional time-resolved TEM techniques have several limitations. The need for ultrafast electron pulses requires sophisticated and expensive equipment, such as laser-driven photocathodes and high-speed detectors. Additionally, the temporal resolution is limited by the duration of the electron pulses and the precision of the synchronization between the pump and probe pulses. Stroboscopic imaging, while useful for repetitive processes, may not be suitable for non-repetitive or irreversible events. Furthermore, the reliance on averaging multiple images to improve signal-to-noise ratio can limit the temporal resolution and may introduce artifacts if the process is not perfectly repeatable.

Achieving both high temporal and spatial resolution in time-resolved TEM remains a significant challenge. The need to balance beam intensity with spatial coherence often results in trade-offs that can affect image quality. High-speed cameras and direct electron detectors can capture images at high frame rates, but their performance is limited by the frame rate and the need to minimize motion blur. Additionally, maintaining sample stability under the electron beam and ensuring precise synchronization between the excitation source and the electron pulses are critical for obtaining accurate and reliable time-resolved data.

There is a desire to an improved spatial resolution as well.

It is thus an objective of the present disclosure to provide a method of time-resolved transmission charged particle microscopy with which a resolution improvement in the visualization of the sample can be obtained.

To this end, the disclosure provides a method of time-resolved Transmission Charged Particle Microscopy according to claim 1. The method as provided herein comprises the steps of using a primary source to produce a pulsed beam of charged particles that propagate along a beam path, and providing a specimen at an irradiation position in said beam path.

As disclosed herein, a secondary source is used to produce excitations of the specimen. The secondary source can be a laser that is arranged to excite the specimen, wherein specific settings like pulse duration and synchronization with the electron pulses can be managed by those skilled in the art to ensure precise excitation timing.

As disclosed herein, a detector is used to register a plurality of diffraction patterns resulting from said individual pulses hitting the specimen. Thus, as defined herein, the method according to the disclosure records diffraction patterns, instead of using the conventional way of imaging the specimen in imaging mode with the use of an objective lens.

The method as described herein then uses the step of reconstructing, using a reconstruction algorithm, an image of the specimen from said plurality of diffraction patterns. One possible example of such an algorithm that is suitable for this task is formed by ptychography algorithms. These algorithms are normally used in ptychography, where the sample is illuminated with a condensed beam and the resulting diffraction pattern is recorded for many overlapping beam positions. The ptychography algorithms are then used to retrieve the electrostatic potential of the sample. In the method as described herein, however, the ptychography algorithms can be advantageously used to form an image of the sample from diffraction patterns obtained in time-resolved microscopy experiments.

The invention thus provides a method of time-resolved Transmission Charged Particle Microscopy that significantly enhances resolution through the innovative use of measuring diffraction patterns. By employing a pulsed beam of charged particles and utilizing a secondary source, such as a laser, to excite the specimen, the method ensures that individual pulses hit the specimen. Generally, these individual pulses hit the specimen at a plurality of different locations. This strategic excitation allows for the collection of a rich dataset of diffraction patterns, which are then used to reconstruct high-resolution images of the specimen. The use of a detector optimized for capturing these diffraction patterns, rather than conventional imaging, enables the acquisition of detailed structural information with improved accuracy and precision.

One of the primary advantages of this method is the substantial improvement in spatial resolution. Traditional time-resolved TEM techniques often struggle with maintaining high resolution due to limitations in beam coherence and the need to average multiple images. By contrast, the ptychographic approach leverages overlapping diffraction patterns and advanced reconstruction algorithms to resolve fine structural details that are typically beyond the reach of conventional methods. This results in images with significantly higher clarity and detail, allowing researchers to observe and analyze nanoscale phenomena with unprecedented precision.

The method's ability to synchronize the primary beam (such as a pulsed electron beam) with a secondary beam-induced excitations (laser-based, for example) enables the capture of dynamic processes within the specimen at very short time intervals. This is particularly beneficial for studying fast transient phenomena such as phase transitions, chemical reactions, and mechanical vibrations. By capturing a sequence of diffraction patterns at different time points, the method provides a comprehensive temporal map of the specimen's behavior, offering valuable insights into its dynamic properties and processes.

Overall, the invention represents a significant advancement in the field of time-resolved TEM. The method as defined herein overcomes many of the limitations of traditional methods, offering improved spatial resolution, enhanced image quality, and greater flexibility in studying dynamic processes at the nanoscale.

Generally speaking, the use of the secondary source to produce excitations of the specimen causes individual pulses of the pulsed beam of charged particles to hit the specimen at a plurality of different locations. In traditional time-resolved TEM, this effect typically decreased spatial resolution. However, with the method described herein, this spread is advantageously utilized to increase spatial resolution through ptychographic reconstruction.

Advantageous embodiments will be discussed below.

In an embodiment, the primary source is used for producing a pulsed beam of electrons. The use of a pulsed electron beam allows for capturing dynamic processes within the specimen with high temporal resolution. By producing electron pulses as short as 1 picosecond, for example, or even as short as 1 femtosecond, the method can observe changes in the specimen's structure at extremely fine time intervals, which is essential for studying fast transient phenomena such as phase transitions, chemical reactions, and mechanical vibrations.

Moreover, the pulsed beam of electrons, in combination with ptychographic reconstruction techniques, enables the collection of high-resolution diffraction patterns. These patterns are recorded at multiple overlapping positions, allowing for the reconstruction of detailed images of the specimen with enhanced spatial resolution. As indicated before, this improvement in resolution provides a more comprehensive understanding of the specimen's dynamic behavior.

In an embodiment, the primary source is used for producing a pulsed beam having pulses in the order of 1 femtosecond (fs), to 1 picosecond (ps). Pulses in the order of 1 nanosecond (ns) are conceivable as well. The ability to generate electron pulses within this wide range of durations allows the method to capture dynamic processes occurring over various timescales. For ultrafast events, such as electronic transitions and chemical reactions, pulses as short as 1 ps provide the necessary temporal resolution to observe these rapid changes in real-time. Conversely, for slower processes like mechanical vibrations and heat flow, pulses up to 1 ns can be used to capture the relevant dynamics without sacrificing resolution.

This flexibility in pulse duration enhances the versatility of the time-resolved TEM method as disclosed herein, making it suitable for a broader range of applications. Researchers can tailor the pulse duration to the specific dynamic process under investigation, ensuring that the temporal resolution is optimized for each experiment.

In an embodiment, the primary source produces a beam with substantial spatial coherency. For example, in TEM, the beam may be characterized by a coherence length on the order of 10 to 50 nanometers. This means that while the electron beam is not perfectly coherent, it retains enough coherence for high-resolution imaging. Substantial spatial coherency may, alternatively, be defined by the incoherent source size. Typically, for STEM applications the incoherent source size ranges from about 2 picometer to about 100 picometer, with larger metrics being a sign of more incoherence (i.e. less spatial coherency). In view of the present disclosure, a beam with substantial spatial coherency is then obtained when the incoherent source size is less than 50 picometer. The term " spatial coherence" reflects the fact that electrons originate from a small area rather than a single point, resulting in a beam with measurable coherence width.

Using a beam with substantial spatial coherency ensures the electron pulses maintain sufficient coherence to produce clear and detailed diffraction patterns. These patterns are beneficial for the ptychographic reconstruction process, which relies on overlap of the diffraction data to accurately reconstruct high-resolution images. Simultaneously, maintaining coherence allows for higher beam intensity, necessary for achieving sufficient signal strength in ultrafast time-resolved experiments. In this regard, ptychography allows to work with a beam that has less coherence than what is used for conventional imaging, whilst still being able to obtain high-resolution images. This approach will give more signal and would allow for shorter acquisitions, thus making it easier to characterize drift.

This balance between coherence and intensity enhances the method's ability to capture fine structural details while observing dynamic processes. It allows researchers to achieve high spatial resolution without compromising the temporal resolution needed for studying fast transient phenomena. By optimizing the degree of coherence, the method offers a versatile and powerful tool for applications in materials science, biology, and nanotechnology, representing a significant improvement over traditional methods that often struggle to balance coherence and intensity effectively.

In an embodiment, the secondary source is a laser beam. Using a laser beam as the secondary source allows for precise and controlled excitation of the specimen. Laser pulses can be finely tuned in terms of duration, energy, and repetition rate, providing the flexibility to induce and study a wide range of dynamic processes within the specimen. The use of a laser beam enables the initiation of repeatable and reproducible temporal processes such as phase transitions, plasmonic excitations, mechanical vibrations, ablative processes, heat flow, and chemical reactions. The precise control over the laser parameters ensures that the specimen can be excited in a highly controlled manner, allowing for the synchronization of the laser pulses with the pulsed electron beam. This synchronization is beneficial for capturing the dynamic changes in the specimen at very fine time intervals.

Moreover, the laser-induced excitations can be tailored to specific experimental needs, enhancing the versatility of the method. For example, by adjusting the pulse duration and energy, researchers can study both ultrafast phenomena and slower processes with high temporal resolution. This capability is particularly important for optimizing the conditions under which the diffraction patterns are recorded, ensuring that the resultant data is of high quality and suitable for ptychographic reconstruction. Overall, the use of a laser beam as the secondary source significantly enhances the method's capability to study a wide range of dynamic processes with high precision and control.

In an embodiment, the method comprises the step of moving the specimen relative to the pulsed beam. This may be obtained by scanning the beam over the sample. Alternatively, it is conceivable that the sample is moved with respect to the beam, for example by using stage movements. A combination of beam movement and stage movement is conceivable as well. By moving the specimen relative to the pulsed beam, the method ensures that different regions of the specimen are exposed to the electron pulses, thereby capturing a broader range of data. The relative movement of the specimen allows for the collection of diffraction patterns from multiple, overlapping positions. This provides the redundancy and spatial diversity needed to accurately reconstruct high-resolution images of the specimen using the reconstruction algorithm, for example using ptychography. The movement can be controlled to ensure optimal overlap of the beam positions, enhancing the quality and resolution of the reconstructed images.

It is conceivable that the step of moving the specimen relative to the pulsed beam comprises an uncertainty in the exact relative position of the specimen with respect to the pulsed beam. In other words, it is not required that the relative position of the specimen with respect to the beam is precisely known. The relative movement allows a broader range of data to be captured, which provides the redundancy and spatial diversity needed for the reconstruction algorithms.

Additionally, moving the specimen relative to the pulsed beam helps mitigate the effects of beam damage. By distributing the exposure across different areas of the specimen, the method reduces the risk of localized damage, preserving the integrity of the specimen for extended observation periods. This is particularly beneficial for studying delicate biological samples or materials that are sensitive to electron beam exposure.

Furthermore, the ability to move the specimen relative to the beam enables dynamic studies where the spatial and temporal evolution of the specimen can be observed simultaneously, in particular where processes are investigated that involve large-scale changes or movements within the specimen, such as mechanical deformations, growth phenomena, or chemical reactions.

Overall, the inclusion of the step of moving the specimen relative to the pulsed beam enhances the versatility and effectiveness of the method. It allows for the collection of comprehensive, high-quality data that is essential for detailed ptychographic reconstruction.

In an embodiment, the method comprises the step of moving the specimen relative to the pulsed beam, wherein the moving comprises spontaneous drift of the specimen. This feature leverages the natural, often unavoidable, drift that occurs in specimens during experiments. Instead of trying to minimize this drift, the method uses it advantageously to gather data from slightly different locations of the specimen over time.

Spontaneous drift of the specimen provides a passive means of achieving relative movement between the specimen and the pulsed beam. This drift ensures that different regions of the specimen are exposed to the electron pulses, facilitating the collection of a diverse set of diffraction patterns. This diversity is beneficial for ptychographic reconstruction, as it enhances the redundancy and spatial coverage needed to accurately reconstruct high-resolution images.

Using spontaneous drift as a means of movement simplifies the experimental setup by eliminating the need for additional mechanical components to either move the specimen deliberately, or to keep the specimen substantially still during acquisition. Using spontaneous drift can reduce the complexity and cost of the equipment, making the method more accessible and easier to implement. Additionally, leveraging spontaneous drift can help mitigate the effects of beam damage by distributing the electron exposure across different areas of the specimen naturally.

Historically, achieving atomic-resolution imaging using ultrashort pulses has been a significant challenge, particularly in pump-probe experiments where dynamics of interest are excited. The main issue has been the drift of the sample from shot to shot when irradiated by the laser, which spoils the resolution. Researchers have predominantly focused on minimizing this drift while still triggering the processes of interest. The innovative approach described herein turns this challenge into an advantage. By allowing and utilizing the natural drift, the invention enables more efficient and effective pump-probe experiments, potentially achieving atomic-resolution imaging in real space even when dynamics are excited in the sample.

This innovative use of drift not only simplifies the experimental setup but also enhances the versatility and effectiveness of time-resolved TEM and ptychography. By integrating these advanced techniques, the invention provides a powerful tool for studying dynamic processes at the nanoscale with high spatial and temporal resolution. This makes the method highly applicable to fields such as materials science, biology, and nanotechnology, where understanding the dynamic behavior of specimens is crucial.

In an embodiment, the method comprises the step of moving the specimen relative to the pulsed beam, wherein the moving comprises a scanning motion of the pulsed beam. This feature involves actively controlling the movement of the pulsed beam to scan across the specimen in a systematic manner.

A scanning motion of the pulsed beam provides precise control over the areas of the specimen that are exposed to the electron pulses. This controlled movement allows for the collection of diffraction patterns from specific, predefined locations, ensuring optimal overlap and coverage for ptychographic reconstruction. The ability to precisely scan the beam enhances the quality and resolution of the reconstructed images by providing high-quality, consistent data.

Furthermore, scanning the pulsed beam enables targeted investigations of specific regions of interest within the specimen. Researchers can focus on areas where dynamic processes are occurring, allowing for detailed studies of localized phenomena. This capability is particularly useful for examining heterogeneous specimens where different regions may exhibit distinct behaviors or properties.

By incorporating a scanning motion of the pulsed beam, the method gains flexibility and control, allowing for tailored data collection strategies that optimize both spatial and temporal resolution.

Embodiments of parameters will be discussed below.

In an embodiment, the primary source produces a pulsed beam of electrons with pulse durations ranging from 1 femtosecond (fs) to 1 nanosecond, in particular from 1 femtosecond (fs) to 1 picosecond (ps). This range allows the method to capture dynamic processes occurring over various timescales, from ultrafast electronic transitions to slower mechanical vibrations.

In an embodiment, the electron beam has a coherence length of 10 to 50 nanometers (nm), or an incoherent source size of less than 50 picometers, ensuring sufficient coherence for high-resolution imaging while maintaining higher beam intensity.

In an embodiment, the secondary source, such as a laser beam, produces excitations with pulse durations typically between 100 femtoseconds (fs) and 1 picosecond (ps), synchronized with the electron pulses at repetition rates up to 1 MHz.

In an embodiment, a beam is used with substantial spatial coherency and maintaining an overlap between beam positions of 50% to 80%. This allows accurate ptychographic reconstruction to be used. This embodiment may result in spatial resolutions down to sub-nanometer levels (e.g., 0.1 nm to 1 nm) and temporal resolutions as fine as 1 picosecond (ps).

In an embodiment, spontaneous drift of the specimen is used, quantified by drift rates in nanometers per second (nm/s), to gather diverse data from different locations over time.

The method as described makes use of one or more reconstruction algorithms, for forming an image of the specimen from said plurality of diffraction patterns. Examples of algorithms that may be used in the method as described herein include the Extended Ptychographical Iterative Engine (ePIE), the Ptychographical Iterative Engine (PIE), the Relaxed Ptychographical Iterative Engine (rPIE), Alternating Projections (AP), the Difference Map (DM), the Maximum Likelihood (ML) algorithm, the Regularized Optimization for Ptychography (ROP) algorithm, and the Wigner Distribution Deconvolution (WDD) method. These algorithms iteratively refine the estimated object and probe functions, ensuring accurate reconstruction of high-resolution images from the collected diffraction patterns.

As disclosed herein, the disclosure provides a microscopy system for performing time-resolved Transmission Charged Particle Microscopy according to claim 9. The microscopy system as defined herein comprises a primary source, for producing a pulsed beam of charged particles that propagate along a beam path. The system also comprises a specimen holder, for holding a specimen at an irradiation position in said beam path. Additionally, the system comprises a secondary source to produce excitations of a specimen provided in said beam path.

The microscopy system as described herein comprises a detector that is arranged to register a plurality of diffraction patterns resulting from said individual pulses hitting the specimen.

Furthermore, the system comprises an electronic controller, for administering operational characteristics of the microscope.

The system also comprises a computing device that is arranged for receiving said plurality of diffraction patterns from said detector, and for reconstructing, using a reconstruction algorithm, an image of the specimen from said plurality of diffraction patterns.

This microscopy system as defined herein allows to perform high-resolution, time-resolved Transmission Charged Particle Microscopy with the method as defined herein, enabling the detailed study of dynamic processes within specimens.

Detailed settings of the microscope system will be explained below.

In an embodiment, the primary source for producing a pulsed beam of charged particles that propagate along a beam path is an electron gun. This electron gun can be a field emission gun or a thermionic gun, capable of generating pulses with durations ranging from 1 picosecond to 1 nanosecond. Beam energies may range between 50 keV and 300 keV, in particular in between 100 keV and 300 keV. The beam may exhibit a coherence length of 10 to 50 nanometers, ensuring sufficient spatial coherence for high-resolution imaging.

The specimen holder may be arranged for providing sub-nanometer positioning precision, and may include temperature control capabilities such as cryogenic cooling or heating stages. It allows for x, y, z translations and rotation to position the specimen accurately.

The secondary source may be a laser for producing excitations of a specimen provided in the beam path. The laser can generate pulses with durations ranging from 100 femtoseconds to 1 picosecond, with a repetition rate up to 1 MHz and a wavelength of 800 nm. The energy per pulse can be up to 1 millijoule, enabling precise and controlled excitation of the specimen.

The detector is arranged for registering a plurality of diffraction patterns resulting from the individual pulses hitting the specimen at the plurality of different locations. The detector can be a direct electron detector, CCD, or CMOS, with a resolution of up to 4k x 4k pixels and a frame rate of up to 1000 frames per second. The detector may have a high sensitivity, ensuring accurate capture of diffraction patterns. The detector may, for example, be a Falcon 4i Direct Electron Detector (Thermo Fisher Scientific) having a resolution of 4k x 4k pixels. Other candidates are the Timepix detector (CERN) offering 512 x 448 pixels, Arina (Dectris) with 96x96 pixels or EMPAD (Thermo Fisher Scientific) with 128x128 pixels. It is conceivable that higher resolution detectors will become available in the future, and these detectors can be used in the method as defined herein as well.

The electronic controller for administering operational characteristics of the microscope may be arranged for managing beam control, synchronization with the laser, and specimen movement. It may includes a user interface, such as a touch screen or software interface, for easy operation.

The computing device arranged for receiving the plurality of diffraction patterns from the detector and for reconstructing, using a reconstruction algorithm, an image of the specimen from the plurality of diffraction patterns. The computing device may feature, for example, a high-performance CPU and GPU. It is arranged for running software capable of executing ptychographic algorithms and processing large datasets efficiently.

In an embodiment, the microscopy system comprises a transmission charged particle microscope. In other words, the transmission charged particle microscope is part of the microscopy system. The transmission charged particle microscope, in this embodiment, includes the primary source for producing a pulsed beam of charged particles, the specimen holder for holding a specimen at an irradiation position in the beam path, the secondary source for producing excitations of the specimen, the detector for registering a plurality of diffraction patterns resulting from the individual pulses hitting the specimen at different locations, and the electronic controller for administering the operational characteristics of the microscope.

Additionally, the system comprises a computing device that is directly or indirectly connectable to the transmission charged particle microscope for receiving the diffraction patterns from the charged particle microscope. This connectivity ensures seamless data transfer between the microscope and the computing device, enabling efficient processing and reconstruction of high-resolution images from the collected diffraction patterns. The integration of these components within the transmission charged particle microscope provides a comprehensive and highly functional system for performing advanced time-resolved Transmission Charged Particle Microscopy.

The computing device in the microscopy system can be configured in various embodiments to meet different operational needs and constraints. These embodiments include:
- Local High-Performance Workstation: A dedicated workstation with high-end CPUs, GPUs, and ample RAM and storage, directly connected to the transmission charged particle microscope for real-time data processing and reconstruction.
- Networked Server: A centralized server with powerful processing capabilities and large-scale storage, connected to the microscope via high-speed Ethernet, providing centralized data processing within the same facility.
- Cloud Computing Platform: Utilizing cloud computing resources to perform ptychographic reconstruction, offering scalability and remote accessibility. This setup allows diffraction patterns to be uploaded to a cloud platform, where intensive computational tasks are carried out, and results are downloaded.
- Hybrid System: Combining local computing resources and cloud computing to balance performance and cost. Initial data processing is performed locally, while intensive reconstruction tasks are offloaded to the cloud.
- Edge Computing Device: A compact, high-performance device located near the microscope to perform initial data processing and filtering, reducing the volume of data before transferring it to a central server or cloud platform for further analysis.

It is noted that the microscopy system for performing time-resolved Transmission Charged Particle Microscopy can be configured with various primary and secondary sources to suit specific experimental needs.

The primary source may be a Field Emission Gun (FEG) that provides high brightness and excellent coherence, ideal for high-resolution imaging. Alternatively, the primary source may be a Thermionic Emission Gun that uses a heated filament for electron emission, offering stability and simplicity for general-purpose microscopy. Alternatively, the primary source may be a Photoemission Electron Source that is arranged for producing ultrafast electron pulses through laser illumination of a photocathode, enabling high temporal resolution. Finally, the primary source may be a Plasma-Based Electron Source that is arranged for generating a dense and high-energy electron beam, suitable for applications requiring high electron flux. It is noted that obviously these sources can be used in the method as disclosed herein as well.

The secondary source may be a Laser (such as an Ultrafast Laser) that produces (ultrafast) light pulses for precise excitation of the specimen, suitable for pump-probe experiments. Alternatively, the secondary source may be a focused ion beam (FIB) that excites the specimen by sputtering or implanting ions, enabling material modification, inducing damage or defects, and studying ion-solid interactions. Alternatively, a thermal source, such as a laser or a heating stage, can be used that increases the specimen's temperature, facilitating the study of thermal effects, phase transitions, and heat flow in materials. Alternatively, an electrical source can be used for applying a voltage or current to the specimen, inducing electrical excitations, studying electrical properties, and generating electron-hole pairs in semiconductors. Alternatively, a mechanical source can be used in the form of mechanical actuators that apply stress or strain to the specimen, allowing the study of mechanical properties, inducing deformations, and observing stress-induced phase transitions. A combination of multiple sources is conceivable as well. A preferred embodiment makes use of a laser beam as a secondary source.

### Brief description of the drawings

For a more thorough understanding of the present disclosure, and advantages thereof, reference is now made to the following descriptions taken in conjunction with the accompanying drawings, in which:
Fig. 1 shows a longitudinal cross-sectional view of a charged particle microscope, in particular a transmission charged particle microscope;
Fig. 2 shows a flow diagram of the method as described herein;
Fig. 3a-3d show a recording scheme in line with the method as described herein;
Fig. 4 shows a flow diagram of the reconstruction method as described herein;
Fig. 5 shows results of numerical simulations of the method as described herein;
Fig. 6 shows a reproduction of the Shepp-Logan Phantom image.

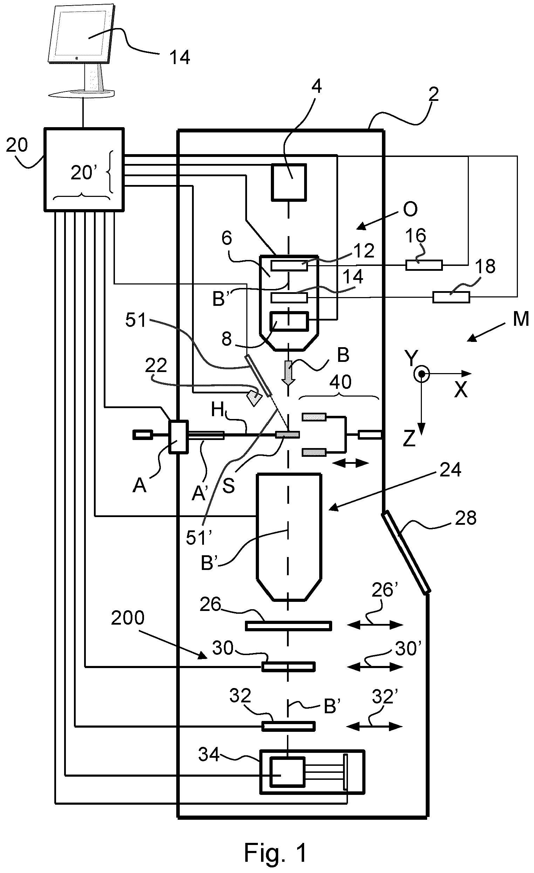

FIG. 1 is a highly schematic depiction of an embodiment of a Charged Particle Microscope (CPM) system. In this case, the CPM is a Scanning/Transmission Electron Microscope ((S)TEM), though, in the context of the current invention, it could just as validly be an ion-based or proton microscope, for example.

Within a vacuum enclosure 2, an electron source 4 produces a beam (B) of electrons that traverse an electron-optical illuminator 6. The illuminator 6 directs and focuses the beam onto a chosen part of a specimen S, which may be locally thinned or planarized. The illuminator 6, aligned along an electron-optical axis B', comprises various electrostatic/magnetic lenses, scan deflectors 8, correctors (such as stigmators), and may include a condenser system.

The illuminator 6 comprises, in the embodiment shown, a resonant radio-frequency (RF) cavity 12. The RF cavity 12 can be configured to operate in the transverse magnetic TM110 mode so that it can function as a dynamic electron-optical element within an electron microscope. In this mode, the electromagnetic field distribution is characterized by a magnetic field component that is purely transverse to the direction of propagation, and an electric field with a longitudinal component. The TM110 mode exhibits an azimuthal variation in the magnetic field and produces a time-varying transverse electromagnetic field across the beam path. When a continuous electron beam traverses this cavity, the transverse field induces a deflection that is dependent on the arrival time of each electron. This time-dependent deflection can be exploited to convert a continuous electron beam into a sequence of short pulses when combined with an aperture or slit. Alternatively, it can be used to temporally resolve ultrafast dynamics by mapping time to spatial position. Incorporating a dielectric material into the cavity reduces its physical dimensions and enhances power efficiency, supporting integration into compact electron microscopy systems.

The specimen S is held on a specimen holder H, which is mounted in a cradle A'. The cradle A' can be positioned and moved in multiple degrees of freedom by a positioning device (stage) A, allowing displacement in the X, Y, and Z directions and rotation about a longitudinal axis parallel to X. This movement allows different parts of the specimen S to be irradiated, imaged, or inspected by the electron beam along axis B'.

The focused electron beam B interacts with the specimen S, causing various types of stimulated radiation to emanate from the specimen, including secondary electrons, backscattered electrons, X-rays, and optical radiation (cathodoluminescence). These radiation types can be detected with the aid of a sensor 22, such as a combined scintillator/photomultiplier or an Energy-Dispersive X-Ray Spectroscopy (EDX) module.

In TEM or STEM mode, the electrons that traverse the specimen S and continue along axis B' enter an imaging system 24, typically comprising a variety of electrostatic/magnetic lenses, deflectors, and correctors. This system can focus the transmitted electron flux onto a fluorescent screen 26, which can be retracted as indicated by arrows 26'. An image or diffractogram of the specimen S is thus formed on the screen 26, viewable through a port 28.

Alternatively, the electron flux can be directed to various sensing devices downstream of screen 26, such as:
- TEM Camera 30: Captures static images or diffractograms, processed by controller 20 and displayed on a display device 14. The camera can be retracted when not in use, as indicated by arrows 30'.
- STEM Detector 32: Records output as a function of the scanning position of the beam B on the specimen S, creating a map of the detector output. The detector can be retracted when not in use, as indicated by arrows 32'.

For high-temporal-resolution imaging, an HTR detector 34 can be used, as explained below.

Controller/processor 20 is connected to various components via control lines 20', providing functions such as synchronization, setting parameters, processing signals, and displaying information. The controller 20 may be located inside or outside the enclosure 2 and can have a unitary or composite structure.

In the embodiment shown, the microscope M comprises:
- RF Cavity 12: Acts as a beam chopper to pulse the beam from continuous source 4, connected to an electrical excitation source 16.
- Electrostatic Deflector 14: Converts a continuous stream of pulses from cavity 12 into pulse trains, connected to an electrical excitation source 18.
- Secondary Source 51: Produces repetitive excitations 51' of the specimen S, such as laser beam pulses. The operating frequencies of secondary source 51 and deflector 14 are matched, ensuring the specimen receives one primary pulse train per secondary excitation 51'.
- Electron Diffraction Detector 34: A detector that is arranged for detecting diffraction patterns coming from specimen S. The detector 34 can be a CMOS or CCD camera, a direct electron detector, or a pixelated detector. In an embodiment, the Detector 34 is a Timepix or Medipix detector with an integrated array of pixels, each with an individual readout circuit, matching the temporal resolution of the system.

From the above it follows that Fig. 1 shows an embodiment of a microscopy system M for performing time-resolved Transmission Charged Particle Microscopy in line with the method as disclosed herein. The microscopy system M comprises:
- A primary source 4, for producing a pulsed beam of charged particles that propagate along a beam path B;
- A specimen holder H, for holding a specimen S at an irradiation position in said beam path B;
- A secondary source 51 to produce excitations of a specimen (S) provided in said beam path so that the individual pulses of the pulsed beam of charged particles hit the specimen at a plurality of different locations
- A detector (34) to register a plurality of diffraction patterns resulting from said individual pulses hitting the specimen at said plurality of different locations;
- An electronic controller, for administering operational characteristics of the microscope; and
- A computing device (14, 20) that is arranged for receiving said plurality of diffraction patterns from said detector (34), and for reconstructing, using a reconstruction algorithm, an image of the specimen (S) from said plurality of diffraction patterns.

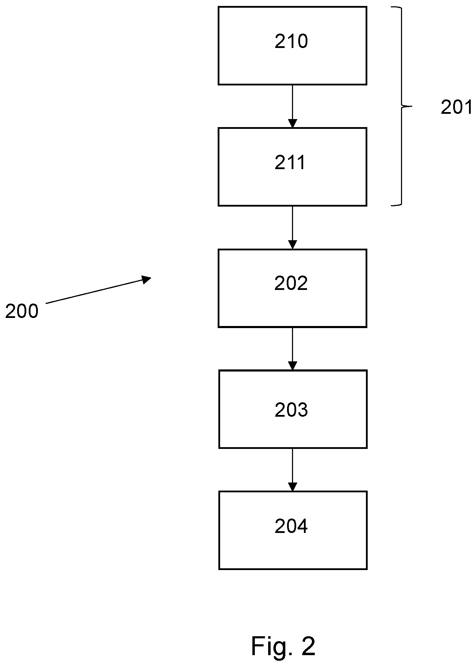

Fig. 2 shows a flow diagram of an embodiment of the method 200 of time-resolved Transmission Charged Particle Microscopy as defined herein. As shown, the method 200 comprises the steps of:
- Using 201 a primary source 4 to produce a pulsed beam of charged particles that propagate along a beam path B;
- Using 202 a secondary source 51 to produce excitations of the specimen S.
- Using 203 a detector 34 to register a plurality of diffraction patterns resulting from said individual pulses hitting the specimen; and
- Reconstructing 204, using a reconstruction algorithm, an image of the specimen S from said plurality of diffraction patterns.

The step 201 of generating a pulsed beam may comprise sub-steps, including the step 210 of using the primary source 4 to produce a beam of charged particles that propagate along a beam path B, and the step 211 of modifying the beam of charged particles into a pulsed beam of charged particles that propagate in the direction of a specimen S provided at an irradiation position in said beam path B. The step 211 of modifying the beam of charged particles into a pulsed beam can be done using an RF cavity as described above with respect to Fig. 1.

The step 201 may comprise the step of using the primary source for producing a pulsed beam of electrons. Once again, this may comprise the step 210 of generating a beam of electrons, and the step 211 of modifying the beam of electrons, using an RF cavity for example, into a pulsed beam of electrons. The pulsed beam of charged particles, such as electrons, may have pulses in the order of 1 fs to 1 ns, in particular in the order of 1 fs to 1 ps.

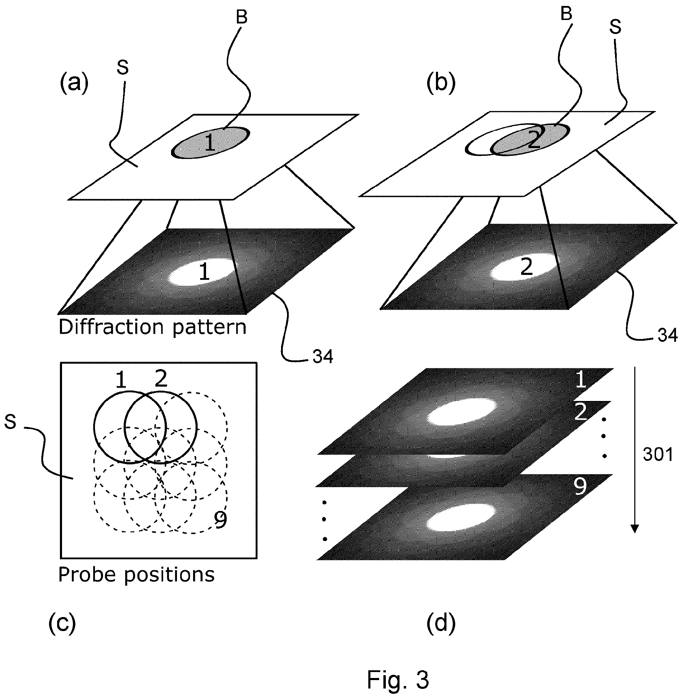

Fig. 3a-3d show a first embodiment of a recording scheme for use in the method of time-resolved Transmission Charged Particle Microscopy. Here, data acquisition comprises imaging using a single-aperture scanning technique. In Fig. 3a, a focused incident radiation beam B is directed at a first position "1" on the specimen S, producing a scattered interference pattern that is recorded by a detector 34 positioned downstream. Fig. 3b shows the subsequent step, in which the specimen S is shifted relative to the incident beam B to a second position "2" that partially overlaps with the first. The corresponding scattered interference pattern is again recorded at the detector 34. This overlapping illumination region can be used for reconstructing the phase information using an algorithm. In an embodiment, ptychographic analysis is used for this. Fig. 3c schematically illustrates multiple overlapping illumination areas across the specimen S surface, where the dotted and dashed circles correspond to overlapping scan positions "1" to "9". Note that there is overlap between some of the scan position, e.g. "1" and "2", but there does not necesseraly have to be overlap between all scan positions. See for example scan positions "1" and "9", which exhibit no overlap. Fig. 3d shows the resulting dataset as a stack 301 of interference patterns in reciprocal space, each corresponding to a different illumination position (x, y) on the specimen S. The overlapping diffraction patterns collected at different positions enable high-resolution phase retrieval and image reconstruction of the specimen, using a reconstruction algorithm, such as ptychographic reconstruction.

Ptychography is a computational imaging technique that reconstructs high-resolution images of a specimen by analysing a series of overlapping diffraction patterns. A localized, coherent probe B is scanned across the specimen S in a two-dimensional grid, where each illumination position partially overlaps with the adjacent ones. At each position, a far-field diffraction pattern is recorded by a detector 34. The overlap between successive illuminated regions introduces redundancy in the data, which is exploited by phase retrieval algorithms to reconstruct both the amplitude and phase of the specimen's transmission function. This allows for quantitative imaging beyond the diffraction limit of the optics. The reconstruction is typically achieved through iterative algorithms such as the ptychographic iterative engine (PIE), extended PIE (ePIE), or maximum likelihood-based methods.

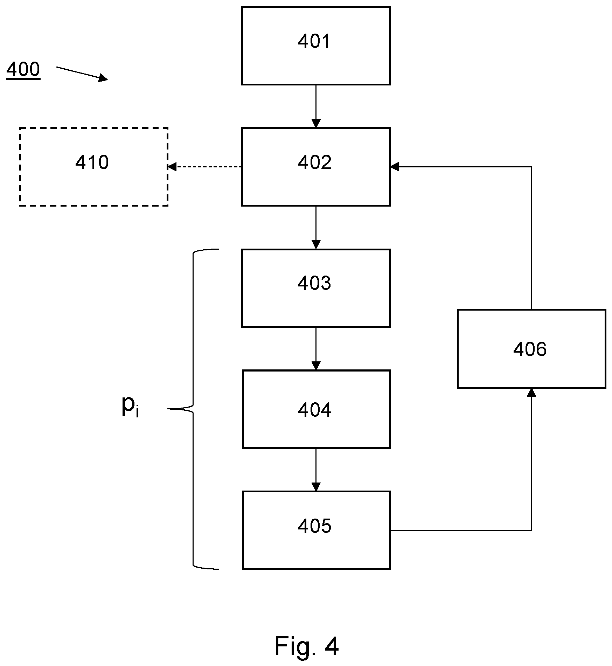

Fig. 4 illustrates a flowchart of a reconstruction algorithm, such as the ptychographic image reconstruction algorithm that can be used in the method as defined herein. Initially, a set of diffraction patterns is acquired at overlapping illumination positions, as described above with respect to Fig. 2 and 3. These diffraction patterns are provided in step 401. The algorithm then begins in step 402 with an estimate of the object and/or illumination probe. For each scan position pᵢ, the algorithm simulates 403 the far-field diffraction pattern using a Fourier transform, replaces 404 the amplitude with the measured intensity data, and applies 405 an inverse Fourier transform to generate a corrected wavefront. This wavefront is then used in step 406 to iteratively update the object and/or probe estimates. The process is repeated until the reconstruction error falls below a predefined threshold (checked in step 410), resulting in a complex-valued image of the specimen comprising both amplitude and phase information.

In an embodiment of the method, the step of reconstructing an image of the specimen comprises ptychographic reconstruction using a derivative-based approach.

The derivative-based approach allows for the selection of various error metrics, including the log-likelihood metric, which provides the lowest reconstruction error. It incorporates regularization techniques to impose prior knowledge, such as atomicity, leading to more accurate reconstructions. Additionally, this method can simultaneously estimate uncertain experimental settings, reducing sensitivity to experimental uncertainties and enhancing robustness.

The inclusion of the multislice formalism allows for accurate modelling of thick specimens by considering multiple scattering events. Derivatives may be efficiently calculated using (automated) differentiation enabling precise implementation of the algorithm.

Practical benefits of this method include reduced dependency on manual settings, enhanced performance with high-quality hardware, and maintained performance with less optimal hardware. Overall, this approach provides flexibility in error metrics, incorporates regularization, estimates experimental settings, and models thick specimens, resulting in more accurate and robust imaging capabilities.

The method of reconstructing may be implemented as follows:
As a starting point, although not essential, an initial reconstruction of the object's electrostatic potential may be performed using conventional techniques, although estimating it at zero is possible as well. Then, regardless of whether the initial reconstruction is used, an appropriate error metric, such as the log-likelihood metric, is defined. Regularization techniques are applied to impose prior knowledge onto the reconstruction. The algorithm simultaneously estimates uncertain experimental settings. The multislice formalism is incorporated to account for multiple scattering events in thick specimens. Derivatives are calculated using automated differentiation. The reconstruction is iteratively refined using the derivative-based approach. The final reconstructed image is obtained, providing a high-resolution, accurate representation of the specimen's electrostatic potential.

Advantageously, the ptychographic reconstruction algorithm can be used in time-resolved Transmission Electron Microscopy (TEM) to increase spatial resolution by at least a factor two. The ability to estimate beam positions enables the use of random sample movements, induced by laser irradiation and/or spontaneous drift, as a scanning mechanism.

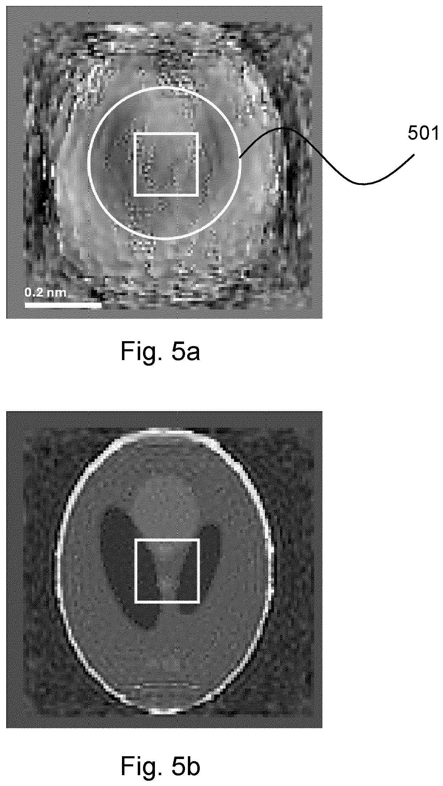

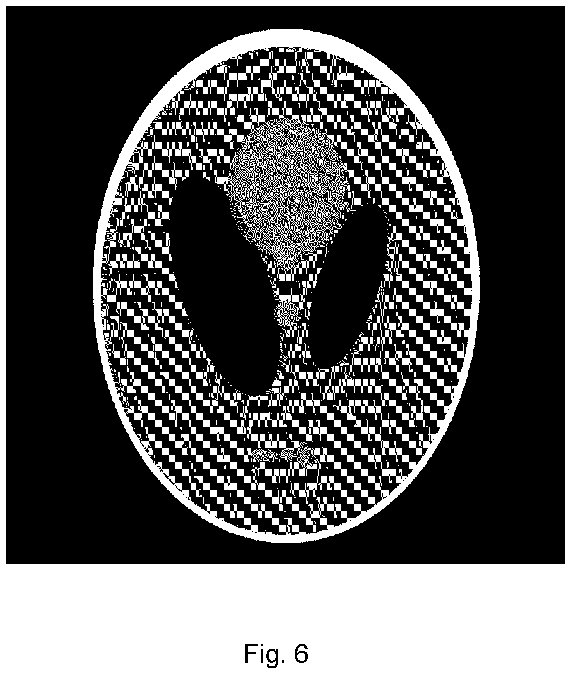

Fig. 5a-5c shows results of simulations of the method as described herein. Using an acceleration voltage of 200 kV, a convergence semi-angle of 30 milliradians, and a defocus of 6.7 nm, a 0.40 nm wide electron beam was formed. One hundred diffraction patterns were simulated from the Shepp-Logan Phantom, a standard test image created by Larry Shepp and Benjamin F. Logan for their 1974 paper "The Fourier Reconstruction of a Head Section". The Shepp-Logan Phantom (See Fig. 6) serves as the model of a human head in the development and testing of image reconstruction algorithms. The simulations included random beam positions within a disc of radius 56 picometers. Poisson noise was added to these patterns to simulate experimental conditions.

When the reconstruction was performed assuming constant beam positions at the origin, the result was not usable (Fig. 5a). Note that in Fig. 5a, circle 501 indicates the beam circumference.

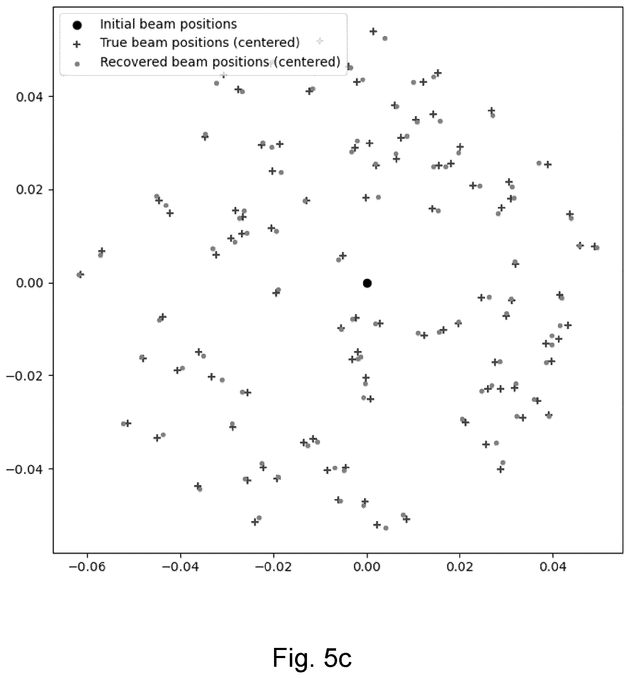

However, when the beam positions were estimated along with the object, both the beam positions and the object were retrieved with high quality (Fig. 5b and Fig. 5c). Note that Fig. 5b and Fig. 5c show simultaneous potential and beam positions optimization with initial values assumed zero (large dot **"●"** in Fig. 5c at x = 0.00 and y = 0.00). Thus, the initial estimate for the beam positions was set to zero (although this is not necessary, and an initial estimate can be used). It can further be seen in Fig. 5c that the true beam positions ("+") closely match the recovered beam positions (smaller dots "• "). This approach demonstrates the effectiveness of using laser-induced sample movements as a scan engine in time-resolved TEM, facilitated by the capability to accurately estimate beam positions during the reconstruction process.

The desired protection is defined by the appended claims.

## Claims

1. A method of time-resolved Transmission Charged Particle Microscopy, **characterized by** the steps of:
- Using a primary source (4') to produce a pulsed beam of charged particles that propagate along a beam path (B');
- Providing a specimen (S) at an irradiation position in said beam path (B');
- Using a secondary source (51) to produce excitations of the specimen (S);
- **characterized by**
- Using a detector (34) to register a plurality of diffraction patterns resulting from said individual pulses hitting the specimen; and
- Reconstructing, using a reconstruction algorithm, an image of the specimen (S) from said plurality of diffraction patterns.

2. Method according to claim 1, wherein the primary source is used for producing a pulsed beam of electrons.

3. Method according to claim 1 or 2, wherein the primary source is used for producing a pulsed beam having pulses in the order of 1 fs to 1 ns, in particular in the order of 1 fs to 1 ps.

4. Method according to claim 1-3, wherein the primary source is used for producing a beam with substantial spatial coherency.

5. Method according to claim 1-4, wherein the secondary source is a laser beam.

6. Method according to claim 1-5, comprising the step of moving the specimen relative to the pulsed beam.

7. Method according to claim 6, wherein moving comprises spontaneous drift of the specimen.

8. Method according to claim 6 or 7, wherein moving comprises a scanning motion of the pulsed beam.

9. Microscopy system for performing time-resolved Transmission Charged Particle Microscopy, comprising:
- A primary source, for producing a pulsed beam of charged particles that propagate along a beam path;
- A specimen holder, for holding a specimen at an irradiation position in said beam path;
- A secondary source (51) to produce excitations of a specimen (S) provided in said beam path so that the individual pulses of the pulsed beam of charged particles hit the specimen (S) at a plurality of different locations for producing repetitive excitations of the specimen (S);
- A detector (34) to register a plurality of diffraction patterns resulting from said individual pulses hitting the specimen (S) at said plurality of different locations;
- An electronic controller (20), for administering operational characteristics of the microscope; and
- A computing device (14, 20) that is arranged for receiving said plurality of diffraction patterns from said detector (34), and for reconstructing, using a reconstruction algorithm, an image of the specimen (S) from said plurality of diffraction patterns.

10. Microscopy system according to claim 9, comprising a transmission charged particle microscope, said transmission charged particle microscope comprising said primary source (4), said specimen holder (H), said secondary source (51), said detector (34) and said electronic controller (20), and wherein said computing device (14, 20) is directly or indirectly connectable to said transmission charged particle microscope for receiving said diffraction patterns from said charged particle microscope.
